# EUROPEAN PATENT APPLICATION

(11) **EP 4 412 094 A1**
(43) Date of publication of application: **07.08.2024**
(21) Application number: 23817290.2
(22) Date of filing: 12.12.2023
(51) Int. Cl.: H04B 1/40, H03L 7/093, H03L 7/097, H03L 7/099, H04B 17/18, H04B 1/04

(54) **METHOD FOR REDUCING VCO COUPLING AND ELECTRONIC DEVICE SUPPORTING SAME**

(30) Priority: 12.12.2022 KR 20220173038; 13.01.2023 KR 20230005226
(71) Applicant: Samsung Electronics Co., Ltd., Suwon-si, Gyeonggi-do 16677 (KR)
(72) Inventor: LEE, Youngmin, Suwon-si, Gyeonggi-do 16677 (KR); NA, Hyoseok, Suwon-si, Gyeonggi-do 16677 (KR); RYU, Gyeonghun, Suwon-si, Gyeonggi-do 16677 (KR)
(74) Representative: Arnold & Siedsma
(86) International application number: PCT/KR2023/020448
(87) International publication number: WO 2024/128762

(57) **Abstract**

According to an embodiment, there may be provided an electronic device comprising an RF circuit and a communication processor operatively connected to the RF circuit, wherein the RF circuit includes at least one reception circuit, at least one transmission circuit, a first VCO, a second VCO, and a signal detection block electrically connected to the first VCO, and wherein the communication processor is configured to control the RF circuit to change an operating frequency of the second VCO based on identifying that a signal output from the first VCO is an abnormal signal. Other various embodiments may be possible.

## Description

### Technical Field

The disclosure relates to a method for reducing VCO coupling and an electronic device for supporting the same.

### Background Art

As mobile communication technology evolves, multi-functional portable terminals are commonplace and, to meet increasing demand for radio traffic, vigorous efforts are underway to develop 5G communication systems. To achieve a higher data transmission rate, 5G communication systems are being implemented on ultra-high frequency bands as well as those used for 3G communication systems and long-term evolution (LTE) communication systems.

For example, to mitigate pathloss on the mmWave band and increase the reach of radio waves, the following techniques are taken into account for the 5G communication system: beamforming, massive multi-input multi-output (MIMO), full dimensional MIMO (FD-MIMO), array antenna, analog beamforming, and large scale antenna.

Wireless communication systems are evolving to support a higher data rate to meet the demand for steadily increasing radio data traffic. Electronic devices may transmit and receive signals having 4G frequencies, 5G sub6 frequencies, and 3 GHz to 5 GHz frequencies to enhance network access and data transmission rates.

A radio frequency front end (RFFE) and an RF circuit of an electronic device may include more components to support carrier aggregation (CA) and E-UTRA new radio dual-connectivity (ENDC). The space for disposing the components of the RFFE and the RF circuit is gradually decreasing due to an increase in the size of the battery of the electronic device.

### Disclosure of Invention

### Solution to Problems

According to an embodiment of the disclosure, an electronic device may comprise an RF circuit and a communication processor operatively connected to the RF circuit. The RF circuit of the electronic device may be configured to include at least one reception circuit, at least one transmission circuit, a first VCO, a second VCO, and a signal detection block electrically connected to the first VCO. The communication processor of the electronic device may be configured to control the RF circuit to change an operating frequency of the second VCO based on identifying whether a signal output from the first VCO is an abnormal signal.

According to an embodiment of the disclosure, a method for operating an electronic device may comprise detecting or identifying a signal output from a first VCO included in an RF circuit of the electronic device through a signal detection block included in the RF circuit. The method for operating the electronic device may comprise identifying whether the detected or identified signal is an abnormal signal (e.g. the detected signal is identified as normal or abnormal) based on identifying a strength of the detected or identified signal. The method for operating the electronic device may comprise controlling the RF circuit to change an operating frequency of a second VCO included in the RF circuit based on identifying that the detected or identified signal is an abnormal signal.

According to an embodiment of the disclosure, in a non-transitory storage medium storing instructions, the instructions may be configured to, when executed by at least one circuit of an electronic device, enable the electronic device to perform at least one operation. The at least one operation may include identifying a signal output from a first VCO included in an RF circuit of the electronic device through a signal detection block included in the RF circuit. The at least one operation may include identifying whether the identified signal is an abnormal signal based on identifying a strength of the identified signal. The at least one operation may include controlling the RF circuit to change an operating frequency of a second VCO included in the RF circuit based on identifying that the identified signal is an abnormal signal.

An embodiment of the disclosure is not limited to the foregoing objectives, and other objectives would readily be appreciated by a skilled artisan from the following detailed description taken in conjunction with the accompanying drawings.

### Brief Description of Drawings

FIG. 1 is a block diagram illustrating an electronic device in a network environment according to an embodiment of the disclosure;
FIG. 2A is a block diagram illustrating an electronic device for supporting legacy network communication and 5G network communication according to an embodiment of the disclosure;
FIG. 2B is a block diagram illustrating an electronic device for supporting legacy network communication and 5G network communication according to an embodiment of the disclosure;
FIG. 3 is a block diagram illustrating an electronic device according to an embodiment of the disclosure;
FIG. 4 is a block diagram illustrating a RFIC according to an embodiment of the disclosure;
FIG. 5 is a view illustrating each component included in an RFIC according to an embodiment of the disclosure;
FIGS. 6A, 6B, and 6C are views illustrating an example of coupling between VCOs according to an embodiment of the disclosure;
FIG. 7 is a block diagram illustrating a signal detection block according to an embodiment of the disclosure;
FIG. 8 is a flowchart illustrating an operation of changing an operating frequency of a VCO of an electronic device according to an embodiment of the disclosure;
FIG. 9 is a flowchart illustrating an operation of changing an operating frequency of a VCO based on a strength of a signal received through a reception circuit by an electronic device according to an embodiment of the disclosure;
FIG. 10 is a flowchart illustrating an operation of changing an operating frequency of a VCO based on identifying a lookup table by an electronic device according to an embodiment of the disclosure; and
FIG. 11 is a flowchart illustrating an operation of changing a reference clock based on identifying a lookup table by an electronic device according to an embodiment of the disclosure.

### Mode for the Invention

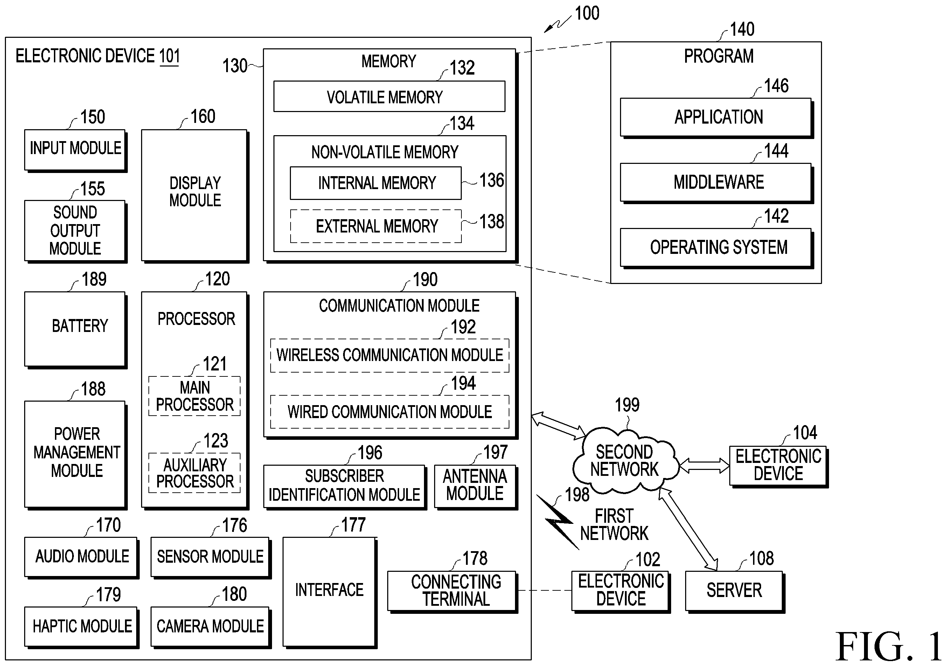

FIG. 1 is a block diagram illustrating an electronic device 101 in a network environment 100 according to an embodiment of the disclosure.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

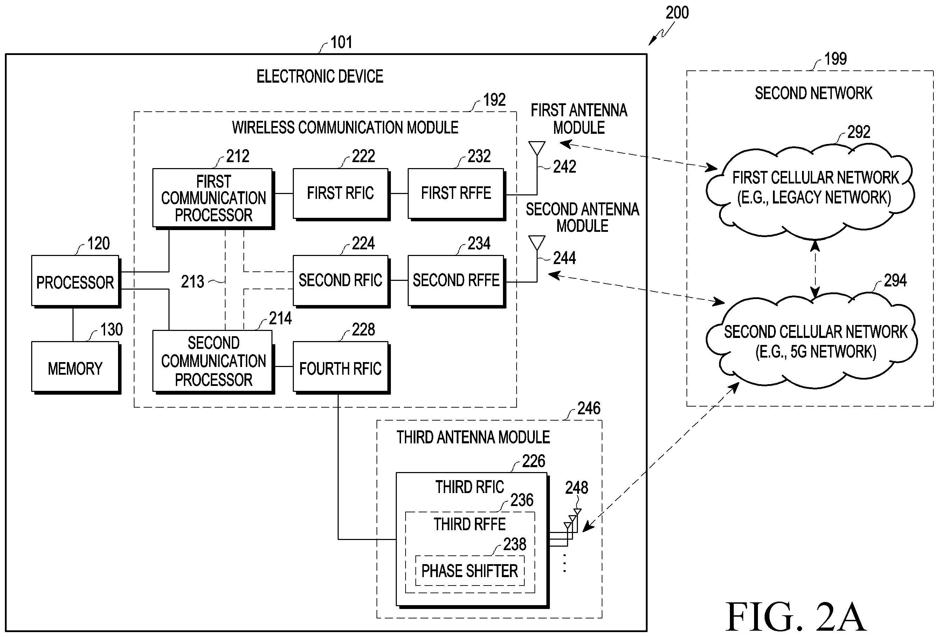

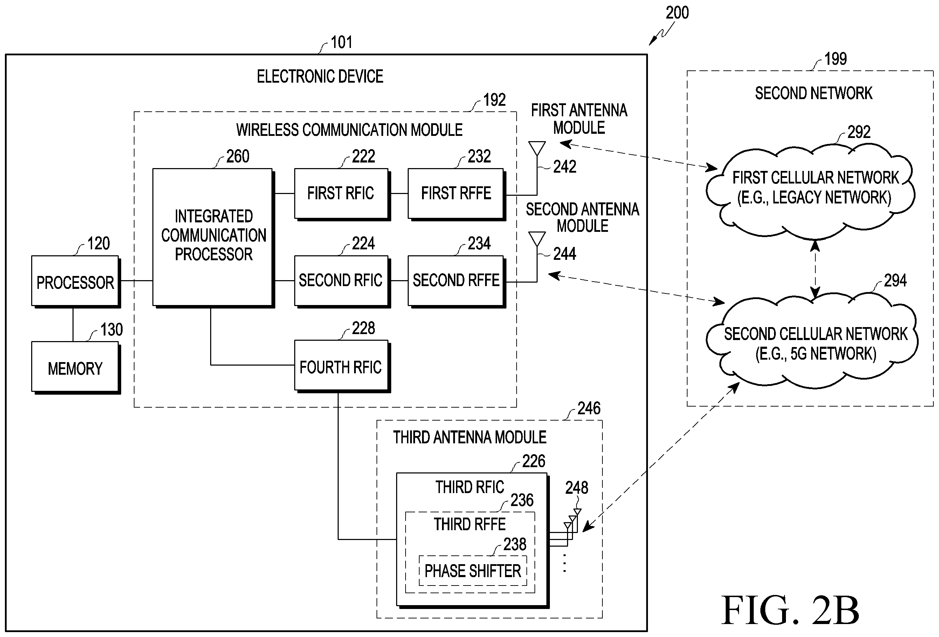

FIG. 2A is a block diagram illustrating an electronic device for supporting legacy network communication and 5G network communication according to an embodiment. FIG. 2B is a block diagram illustrating an electronic device for supporting legacy network communication and 5G network communication according to an embodiment.

Referring to FIG. 2A, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, a third antenna module 246, and antennas 248. The electronic device 101 may further include a processor 120 and a memory 130. The second network 199 may include a first cellular network 292 and a second cellular network 294. According to an embodiment, the electronic device 101 may further include at least one component among the components of FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least part of the wireless communication module 192. According to another embodiment, the fourth RFIC 228 may be omitted or be included as part of the third RFIC 226.

The first communication processor 212 may establish a communication channel of a band that is to be used for wireless communication with the first cellular network 292 or may support legacy network communication via the established communication channel. According to an embodiment, the first cellular network may be a legacy network that includes second generation (2G), third generation (3G), fourth generation (4G), or long-term evolution (LTE) networks. The second communication processor 214 may establish a communication channel corresponding to a designated band (e.g., from about 6GHz to about 60GHz) among bands that are to be used for wireless communication with the second cellular network 294 or may support fifth generation (5G) network communication via the established communication channel. According to an embodiment, the second cellular network 294 may be a 5G network defined by the 3rd generation partnership project (3GPP). Additionally, according to an embodiment, the first CP 212 or the second CP 214 may establish a communication channel corresponding to another designated band (e.g., about 6GHz or less) among the bands that are to be used for wireless communication with the second cellular network 294 or may support fifth generation (5G) network communication via the established communication channel.

The first communication processor 212 may perform data transmission/reception with the second communication processor 214. For example, data classified as transmitted via the second cellular network 294 may be changed to be transmitted via the first cellular network 292. In this case, the first communication processor 212 may receive transmission data from the second communication processor 214. For example, the first communication processor 212 may transmit/receive data to/from the second communication processor 214 via an inter-processor interface 213. The inter-processor interface 213 may be implemented as, e.g., universal asynchronous receiver/transmitter (UART) (e.g., high speed-UART (HS-UART)) or peripheral component interconnect bus express (PCIe) interface, but is not limited to a specific kind. The first communication processor 212 and the second communication processor 214 may exchange packet data information and control information using, e.g., a shared memory. The first communication processor 212 may transmit/receive various types of information, such as sensing information, information about output strength, and resource block (RB) allocation information, to/from the second communication processor 214.

According to implementation, the first communication processor 212 may not be directly connected with the second communication processor 214. In this case, the first communication processor 212 may transmit/receive data to/from the second communication processor 214 via a processor 120 (e.g., an application processor). For example, the first communication processor 212 and the second communication processor 214 may transmit/receive data to/from the processor 120 (e.g., an application processor) via an HS-UART interface or PCIe interface, but the kind of the interface is not limited thereto. The first communication processor 212 and the second communication processor 214 may exchange control information and packet data information with the processor 120 (e.g., an application processor) using a shared memory.

According to an embodiment, the first CP 212 and the second CP 214 may be implemented in a single chip or a single package. According to an embodiment, the first communication processor 212 or the second communication processor 214, along with the processor 120, an assistance processor 123, or communication module 190, may be formed in a single chip or single package. For example, as shown in FIG. 2B, a communication processor 440 may support all of the functions for communication with the first cellular network 292 and the second cellular network 294.

Upon transmission, the first RFIC 222 may convert a baseband signal generated by the first communication processor 212 into a radio frequency (RF) signal with a frequency ranging from about 700MHz to about 3GHz which is used by the first cellular network 292 (e.g., a legacy network). Upon receipt, the RF signal may be obtained from the first cellular network 292 (e.g., a legacy network) through an antenna (e.g., the first antenna module 242) and be pre-processed via an RFFE (e.g., the first RFFE 232). The first RFIC 222 may convert the pre-processed RF signal into a baseband signal that may be processed by the first CP 212.

Upon transmission, the second RFIC 224 may convert the baseband signal generated by the first CP 212 or the second CP 214 into a Sub6-band (e.g., about 6GHz or less) RF signal (hereinafter, "5G Sub6 RF signal") that is used by the second cellular network 294 (e.g., a 5G network). Upon receipt, the 5G Sub6 RF signal may be obtained from the second cellular network 294 (e.g., a 5G network) through an antenna (e.g., the second antenna module 244) and be pre-processed via an RFFE (e.g., the second RFFE 234). The second RFIC 224 may convert the pre-processed 5G Sub6 RF signal into a baseband signal that may be processed by a corresponding processor of the first communication processor 212 and the second communication processor 214.

The third RFIC 226 may convert the baseband signal generated by the second CP 214 into a 5G Above6 band (e.g., from about 6GHz to about 60GHz) RF signal (hereinafter, "5G Above6 RF signal") that is to be used by the second cellular network 294 (e.g., a 5G network). Upon receipt, the 5G Above6 RF signal may be obtained from the second cellular network 294 (e.g., a 5G network) through an antenna (e.g., the antenna 248) and be pre-processed via the third RFFE 236. The third RFIC 226 may convert the pre-processed 5G Above6 RF signal into a baseband signal that may be processed by the second communication processor 214. According to an embodiment, the third RFFE 236 may be formed as part of the third RFIC 226.

According to an embodiment, the electronic device 101 may include the fourth RFIC 228 separately from, or as at least part of, the third RFIC 226. In this case, the fourth RFIC 228 may convert the baseband signal generated by the second communication processor 214 into an intermediate frequency band (e.g., from about 9GHz to about 11GHz) RF signal (hereinafter, "IF signal") and transfer the IF signal to the third RFIC 226. The third RFIC 226 may convert the IF signal into a 5G Above6 RF signal. Upon receipt, the 5G Above6 RF signal may be received from the second cellular network 294 (e.g., a 5G network) through an antenna (e.g., the antenna 248) and be converted into an IF signal by the third RFIC 226. The fourth RFIC 228 may convert the IF signal into a baseband signal that may be processed by the second communication processor 214.

According to an embodiment, the first RFIC 222 and the second RFIC 224 may be implemented as at least part of a single chip or single package. According to an embodiment, when the first RFIC 222 and the second RFIC 224 in FIG. 2A or 2B are implemented as a single chip or a single package, they may be implemented as an integrated RFIC. In this case, the integrated RFIC is connected to the first RFFE 232 and the second RFFE 234 to convert a baseband signal into a signal of a band supported by the first RFFE 232 and/or the second RFFE 234, and may transmit the converted signal to one of the first RFFE 232 and the second RFFE 234. According to an embodiment, the first RFFE 232 and the second RFFE 234 may be implemented as at least part of a single chip or single package. According to an embodiment, at least one of the first antenna module 242 or the second antenna module 244 may be omitted or be combined with another antenna module to process multi-band RF signals.

According to an embodiment, the third RFIC 226 and the antenna 248 may be disposed on the same substrate to form the third antenna module 246. For example, the wireless communication module 192 or the processor 120 may be disposed on a first substrate (e.g., a main painted circuit board (PCB)). In this case, the third RFIC 226 and the antenna 248, respectively, may be disposed on one area (e.g., the bottom) and another (e.g., the top) of a second substrate (e.g., a sub PCB) which is provided separately from the first substrate, forming the third antenna module 246. Placing the third RFIC 226 and the antenna 248 on the same substrate may shorten the length of the transmission line therebetween. This may reduce a loss (e.g., attenuation) of high-frequency band (e.g., from about 6GHz to about 60GHz) signal used for 5G network communication due to the transmission line. Thus, the electronic device 101 may enhance the communication quality with the second cellular network 294 (e.g., a 5G network).

According to an embodiment, the antenna 248 may be formed as an antenna array which includes a plurality of antenna elements available for beamforming. In this case, the third RFIC 226 may include a plurality of phase shifters 238 corresponding to the plurality of antenna elements, as part of the third RFFE 236. Upon transmission, the plurality of phase shifters 238 may change the phase of the 5G Above6 RF signal which is to be transmitted to the outside (e.g., a 5G network base station) of the electronic device 101 via their respective corresponding antenna elements. Upon receipt, the plurality of phase shifters 238 may change the phase of the 5G Above6 RF signal received from the outside to the same or substantially the same phase via their respective corresponding antenna elements. This enables transmission or reception via beamforming between the electronic device 101 and the outside.

The second cellular network 294 (e.g., a 5G network) may be operated independently (e.g., as standalone (SA)) from, or in connection (e.g., as non-standalone (NSA)) with the first cellular network 292 (e.g., a legacy network). For example, the 5G network may have the access network (e.g., 5G radio access network (RAN) or next generation RAN (NG RAN)) but may not have the core network (e.g., next generation core (NGC)). In this case, the electronic device 101, after accessing a 5G network access network, may access an external network (e.g., the Internet) under the control of the core network (e.g., the evolved packet core (EPC)) of the legacy network. Protocol information (e.g., LTE protocol information) for communication with the legacy network or protocol information (e.g., New Radio (NR) protocol information) for communication with the 5G network may be stored in the memory 230 and be accessed by other components (e.g., the processor 120, the first communication processor 212, or the second communication processor 214).

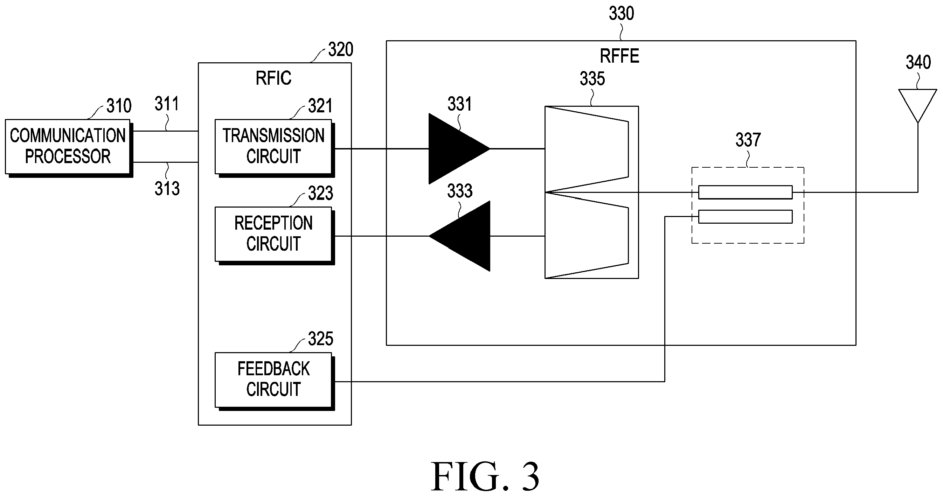

FIG. 3 is a block diagram illustrating an electronic device according to an embodiment of the disclosure.

According to an embodiment, the electronic device 101 may include at least one antenna module 340, at least one RFFE 330 electrically connected to the at least one antenna module 340, at least one RFIC 320 electrically connected to the at least one RFFE 330, and a communication processor 310 operatively connected to the at least one RFIC 320.

In an embodiment, the antenna module 340 may be included in at least one of the antenna module 197 of FIG. 1, the first antenna module 242, the second antenna module 244, or the third antenna module 246 of FIG. 2A.

In an embodiment, the RFFE 330 may be included in at least one of the first RFFE 232, the second RFFE 234, or the third RFFE 236 of FIG. 2A. The RFFE 330 may include at least one power amplification (PA) 331, at least one low noise amplification (LNA) 333, a duplexer 335 electrically connected to the PA 331 and the LNA 333, and a coupler 337 electrically connected to the duplexer 335. The PA 331 may amplify a signal output by the transmission circuit 321 of the RFIC 320. The signal amplified by the PA 331 may be transmitted to the duplexer 335. The LNA 333 may amplify the signal passing through the duplexer 335. The signal amplified by the LNA 333 may be transmitted to the reception circuit 323 of the RFIC 320. The signal amplified by the PA 331 may pass through the duplexer 335. The signal amplified by the PA 331 may be transmitted to the antenna module 340 through the duplexer 335 and the coupler 337. The signal received by the antenna module 340 may pass through the duplexer 335. The received signal may be transmitted to the LNA 333 through the coupler 337 and the duplexer 335. When the signal amplified by the PA 331 passes through the coupler 337, a feedback signal may be generated. The feedback signal generated by the coupler 337 may be transmitted to the feedback circuit 325 of the RFIC 320.

In an embodiment, the RFIC 320 may be included in at least one of the first RFIC 222, the second RFIC 224, the third RFIC 226, or the fourth RFIC 228 of FIG. 2A. The RFIC 320 may be configured to include at least one transmission circuit 321, at least one reception circuit 323, and at least one feedback circuit 325. The RFIC 320 may be electrically connected to the communication processor 310 through a data signal line 311 and a control signal line 313. The RFIC 320 may transmit and receive data to and from the communication processor 310 through the data signal line 311. The RFIC 320 may receive the control signal from the communication processor 310 through the control signal line 313. For example, the RFIC 320 may receive a control signal for controlling at least one of the transmission circuit 321, the reception circuit 323, or the feedback circuit 325 from the communication processor 310 through the control signal line 313. The transmission circuit 321 may generate an RF signal based on receiving a digital signal from the communication processor 310. The reception circuit 323 may generate a digital signal to be transmitted to the communication processor 310 based on receiving an RF signal through the antenna module 340. The feedback circuit 325 may generate a signal for detecting transmission power of the antenna module 340, based on the signal received from the coupler 337.

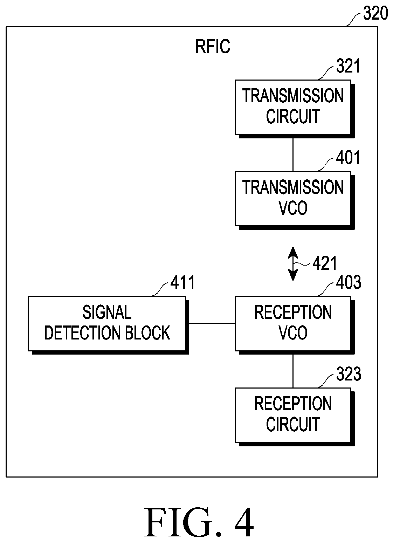

In an embodiment, the communication processor 310 may control an overall operation for reducing coupling between voltage controlled oscillators (hereinafter, referred to as "VCO"). In an embodiment, the communication processor 310 may be included in at least one of the processor 120 of FIG. 1, the first communication processor 212 of FIG. 2A, the second communication processor 214, or the integrated communication processor 260 of FIG. 2B. The operation performed by the communication processor 310 to reduce VCO coupling is described below with reference to FIGS. 4 to 11.

Although FIG. 3 illustrates that the electronic device 101 includes the communication processor 310, the RFIC 320, the RFFE 330, and/or the antenna module 340, the disclosure is not limited thereto. For example, the electronic device 101 may further include at least one component shown in FIG. 1.

FIG. 4 is a block diagram illustrating a RFIC according to an embodiment of the disclosure.

In an embodiment, the RFIC 320 (e.g., at least one of the first RFIC 222, the second RFIC 224, the third RFIC 226, the fourth RFIC 228, or the RFIC 320 of FIG. 3) may be configured to include at least one transmission circuit 321, at least one reception circuit 323, at least one transmission VCO 401 electrically connected to the at least one transmission circuit 321, at least one reception VCO 403 electrically connected to the at least one reception circuit 323, and a signal detection block 411 electrically connected to the reception VCO 403.

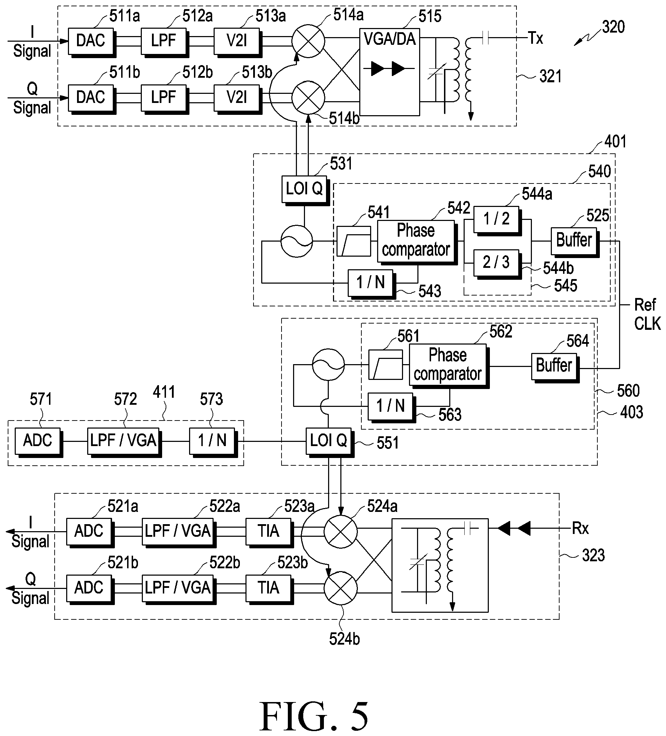

In an embodiment, the RFIC 320 may be configured to include one or more VCOs to transmit and receive signals based on one or more frequency combinations, but is not limited to that illustrated in FIG. 4. The electronic device 101 may support carrier aggregation (CA) or EN-DC based on operations of one or more VCOs. In an embodiment, one VCO may be configured to be electrically connected to eight reception circuits 323. In an embodiment, one reception circuit 323 may be configured to be electrically connected to two or more VCOs. In an embodiment, as the sizes of the elements included in the RFIC 320 decrease, the distance between the VCOs may decrease. When the VCOs are disposed close to each other, coupling may occur due to the inductor included in the VCO. For example, coupling 421 may occur between the transmission VCO 401 and the reception VCO 403. In an embodiment, the electronic device 101 (e.g., the communication processor 310) may identify whether the signal output from the reception VCO 403 is an abnormal signal, based on the operation of the signal detection block 411. The electronic device 101 may control the RFIC 320 to reduce coupling between the VCOs based on identifying that the signal output from the received VCO 403 is an abnormal signal. For example, the electronic device 101 may control the RFIC 320 to change the operating frequency of the transmission VCO 401. An operation in which the electronic device 101 controls the RFIC 320 is described below with reference to FIGS. 5 to 11. In an embodiment, the electronic device 101 may control RF circuit to turn on the signal detection block 411, based on identifying that the transmission circuit 321 operates. Based on identifying that the transmission circuit 321 operates stably, the electronic device 101 may control the RF circuit to turn off the signal detection block 411. For example, the electronic device 101 may control the signal detection block 411 to be turned off after the frequency of the transmission circuit 321 is locked. Based on identifying that the frequency of the transmission circuit 321 is locked, the electronic device 101 may control the signal detection block 411 to be turned off. The electronic device 101 may reduce unnecessary current consumption of the signal detection block 411 based on controlling the signal detection block 411 to be turned on or off.

In an embodiment of the disclosure, the transmission VCO 401 and/or the reception VCO 403 may be referred to as a "first VCO" and/or a "second VCO". In the disclosure, the first VCO or the second VCO is not limited to the transmission VCO 401 or the reception VCO 403. In an embodiment, the electronic device 101 may control the RFIC 320 such that the coupling 421 between the transmission VCO 401 and the reception VCO 403 is reduced. In an embodiment, the electronic device 101 may control at least one RFIC (e.g., at least one of the first RFIC 222, the second RFIC 224, the third RFIC 226, the fourth RFIC 228 of FIGS. 2A and 2B, or the RFIC 320 of FIG. 4) of the electronic device 101 to reduce coupling between different transmission VCOs. The electronic device 101 may control the RFIC 320 to reduce coupling between different reception VCOs.

FIG. 5 is a view illustrating each component included in an RFIC according to an embodiment of the disclosure.

In an embodiment, the transmission circuit 321 included in the RFIC 320 (e.g., at least one of the first RFIC 222, the second RFIC 224, the third RFIC 226, the fourth RFIC 228 of FIG. 2A, the RFIC 320 of FIG. 3, or the RFIC 320 of FIG. 4) may be configured to include digital-to-analog converters (DACs) 511a and 511b, low-pass filters (hereinafter referred to as "LPFs") 512a and 512b, voltage-to-current (V2I) 513a and 513b, mixers 514a and 514b, or an amplifier 515. In an embodiment, the DACs 511a and 511b may convert a digital signal received from the communication processor 310 into an analog signal. The LPFs 512a and 512b may attenuate noise of the analog signal output from the DACs 511a and 511b according to the bandwidth of the transmission signal in the baseband band. The V2Is 513a and 513b may convert a voltage signal into a current signal and transmit the current signal to the mixers 514a and 514b. The mixers 514a and 514b may convert a baseband signal into an RF signal. The amplifier 515 may adjust the power of the transmission RF signal. The amplifier 515 may be implemented as a voltage gain amplifier (VGA) and/or a drive amplifier (DA), but is not limited thereto.

In an embodiment, the reception circuit 323 included in the RFIC 320 may be configured to include an LNA, mixers 524a and 524b, transimpedance amplifiers (TIAs) 523a and 523b, LPFs 522a and 522b, and analog-to-digital converters (ADCs) 521a and 521b. The LNA may amplify an RF signal received through an antenna module (e.g., the antenna module 340 of FIG. 3). The mixers 524a and 524b may convert an RF signal into a baseband signal. The TIAs 523a and 523b may convert a current signal output from the mixers 524a and 524b into a voltage signal. The LPFs 522a and 522b may attenuate noise of an ambient band of a received signal in a baseband. The ADCs 521a and 521b may convert an analog signal output from the LPFs 522a and 522b into a digital signal.

In an embodiment, the reception VCO 403 included in the RFIC 320 may be configured to include a LOIQ 551 and a phase-locked loop (PLL) 560. The LOIQ 551 may be configured to include a signal generator and a frequency divider for generating an IQ signal. For example, the frequency divider may include a 1/2 frequency divider and/or a 1/4 frequency divider. The PLL 560 may include a buffer 564, a phase comparator 562, an LPF 561, and a 1/N frequency divider 563. The buffer 564 may increase the signal strength of the reference clock Ref CLK. The phase comparator 562 may adjust the frequency based on frequency comparison. The LPF 561 may reduce phase noise based on filtering the signal. The 1/N frequency divider 563 may identify the signal output from the reception VCO 403.

In an embodiment, the transmission VCO 401 included in the RFIC 320 may be configured to include a LOIQ 531 and a PLL 540. The LOIQ 531 may be configured to include a signal generator and a frequency divider for generating an IQ signal. For example, the frequency divider may include a 1/2 frequency divider and/or a 1/4 frequency divider. The PLL 540 may include a buffer 525, at least one frequency divider 544a and 544b, a phase comparator 542, an LPF 541, and a 1/N frequency divider 543. The buffer 525 may increase the signal strength of the reference clock. The at least one frequency divider 544a and 544b may change the reference clock. The at least one frequency divider 544a and 544b may include a 1/2 frequency divider 544a and/or a 2/3 frequency divider 544b. In an embodiment, the 1/2 frequency divider 544a and the 2/3 frequency divider 544b may be connected in parallel. In an embodiment, the bypass path 545 may be connected in parallel with the 1/2 frequency divider 544a and the 2/3 frequency divider 544b. When frequency division is not required, the electronic device 101 may control the RFIC 320 so that the signal is transmitted through the bypass path 545. For example, when there is no signal interference due to VCO coupling, the electronic device 101 may control the RFIC 320 so that the signal is transmitted to the bypass path 545. In an embodiment, a state in which a signal is transmitted through the bypass path 545 may be referred to as a "bypass mode". The phase comparator 542 may adjust the frequency based on the frequency comparison. The LPF 541 may reduce phase noise based on filtering the signal. The 1/N frequency divider 543 may identify the signal output from the transmission VCO 401. In an embodiment, the transmission VCO 401 may be configured to operate at a frequency twice as high as the target frequency. For example, the transmission VCO 401 may output a signal of 4.2 GHz so that the electronic device 101 transmits a signal of 2.1 GHz in the B 1 band.

In an embodiment, the signal detection block 411 included in the RFIC 320 may be configured to include a 1/N frequency divider 573, an LPF 572, or an ADC 571. The 1/N frequency divider 573 may convert an RF signal into a baseband signal. The LPF 572 may output only a signal of a band corresponding to the reception circuit 323. LPF 572 may be configured to further include a VGA, but is not limited thereto. The VGA may adjust the power of the signal output from the LPF 572. The ADC 571 may convert an analog signal output from the LPF 572 into a digital signal. The electronic device 101 (e.g., the communication processor 310) may identify the quality of the LO signal output from the LOIQ 551 of the reception VCO 403 and input to the reception circuit 323 based on the operation of the signal detection block 411.

According to an aspect of the disclosure, an electronic device is presented which comprises a memory storing instructions, a radio-frequency (RF) circuit, and a communication processor operatively connected to the memory and the RF circuit. The RF circuit may include a first voltage-controlled oscillator (VCO), a second VCO, and a signal detection block electrically connected to the first VCO and configured to detect (or identify) a signal output from the first VCO. The RF circuit may preferably further comprise a reception circuit (e.g. an Rx chain) and/or a transmission circuit (e.g. a Tx chain). The first VCO may be a reception VCO electrically connected to a reception circuit of the RF circuit. The second VCO may be a transmission VCO electrically connected to a transmission circuit of the RF circuit.

The instructions stored by the memory may preferably cause the electronic device, when executed by the communication processor, to control the RF circuit to change an operating frequency of the second VCO based on identifying that a signal output from the first VCO is an abnormal signal (i.e. is abnormal) when the strength of the signal output from the first VCO as detected by the signal detection block is less than a reference value.

The first VCO may comprise an LOIQ (i.e. a local oscillator in-phase/quadrature generator). The signal detection block may be electrically connected to the LOIQ of the first VCO. Alternatively or additionally, the second VCO may comprise an LOIQ.

The LOIQ may comprise or consist of a generator to form IQ signals and optionally a frequency divider. The transmission and/or reception circuits may be configured to analyze or process IQ signals or I/Q data, i.e. in-phase and quadrature components of an electrical signal.

The signal detection block may be implemented as a local oscillator (LO) signal quality detection block. For example, the role of the LO signal quality detection block can be to check the quality of the LO signal passing from the first VCO (e.g. through the LOIQ thereof) to the reception circuit.

The signal detection block may include a frequency divider electrically connected to the first VCO, a low pass filter electrically connected to the frequency divider, and an analog-to-digital converter (ADC) electrically connected to the low pass filter. Preferably, a variable gain amplifier may be electrically connected to the low pass filter. In this case, the ADC may be electrically connected to the variable gain amplifier. The variable gain amplifier can regulate any lack of power so that the signal can correctly reach the ADC. The ADC may be at a terminal position, i.e. may be a final ADC.

Preferably, the electronic device may further comprise a third VCO. The signal detection block may then include a mixer that is electrically connected to the first VCO (e.g. the LOIQ thereof) and to the third VCO, preferably an LOIQ of the third VCO. A low pass filter may be electrically connected to the mixer and an ADC may be electrically connected to the low pass filter. Optionally, a variable gain amplifier may be electrically connected to the low pass filter and the ADC may be electrically connected to the variable gain amplifier.

Preferably, the signal detection block may be electrically connected to the LOIQ of the first VCO. In this case, it may be further preferred that the instructions, when executed by the communication processor, cause the electronic device to detect a signal output from the LOIQ of the first VCO with the signal detection block, identify whether the detected signal output from the LOIQ of the first VCO is an abnormal signal based on identifying a strength of the detected signal (e.g. the signal output from the LOIQ of the first VCO as detected by the signal detection block is less than a reference value), and control the RF circuit to change the operating frequency of the second VCO when identifying that the detected signal is abnormal.

Preferably, the instructions, when executed by the communication processor, may cause the electronic device to identify the strength of the detected signal based on identifying a signal-to-interference plus-noise ratio (SINR) of the detected signal. The SINR is an example to identify the strength of a signal and other metrics could be used as alternative or in addition.

Preferably, the second VCO may include a phase-locked loop (PLL). The PLL may include a buffer receiving a reference clock, at least one frequency divider electrically connected to the buffer, a phase comparator electrically connected to the at least one frequency divider, and a low pass filter electrically connected to the phase comparator. The at least one frequency divider of the PLL may be implemented as one or more frequency dividers connected in parallel between the buffer and the phase comparator.

When the RF circuit comprises the or at least one reception circuit, it may be preferred that the instructions, when executed by the communication processor, cause the electronic device to control at least one frequency divider of the PLL of the second VCO to change a reference clock of the second VCO based on identifying that the detected signal is abnormal, and/or to control the RF circuit to change an operating frequency of the second VCO when identifying that a strength of a signal received through the reception circuit is less than a reference value.

Alternatively or additionally yet also when the RF circuit comprises the reception circuit, the instructions, when executed by the communication processor, may be configured to cause the electronic device to control the RF circuit to change the operating frequency of the second VCO based on identifying that the SINR of the signal received through the reception circuit is less than a reference value.

Further alternatively or additionally when the RF circuit comprises the reception circuit, the instructions, when executed by the communication processor, may be configured to cause the electronic device to control the RF circuit to change the operating frequency of the second VCO based on identifying that a reference signal received power (RSRP) of the signal received through the reception circuit is a reference value or more.

In particular, it may be envisaged to identify both the SINR as well as the RSRP of the signal received through the reception circuit and control the RF circuit to change the operating frequency of the second VCO based on identifying that the RSRP of the signal received through the reception circuit is a reference value or more and that the SINR of the signal is less than a reference value. In other words, the operating frequency of the second VCO (e.g. reception VCO) will be changed if the SINR is low despite a high RSRP.

In an embodiment, the instructions, when executed by the communication processor, may cause the electronic device to identify a lookup table associated with an operating frequency combination of the electronic device based on identifying that the detected signal is abnormal, control the RF circuit to change the operating frequency of the second VCO based on identifying that the operating frequency combination is a first frequency combination, and control at least one frequency divider of the PLL of the second VCO to change a reference clock of the second VCO based on identifying that the operating frequency combination is a second frequency combination and/or is not the first frequency combination.

When the RF circuit comprises the or at least one transmission circuit, it may be preferred that the instructions, when executed by the communication processor, cause the electronic device to control the RF circuit to turn on the signal detection block based on identifying that the transmission circuit operates and/or to turn off the signal detection block based on identifying that a frequency of the transmission circuit is locked.

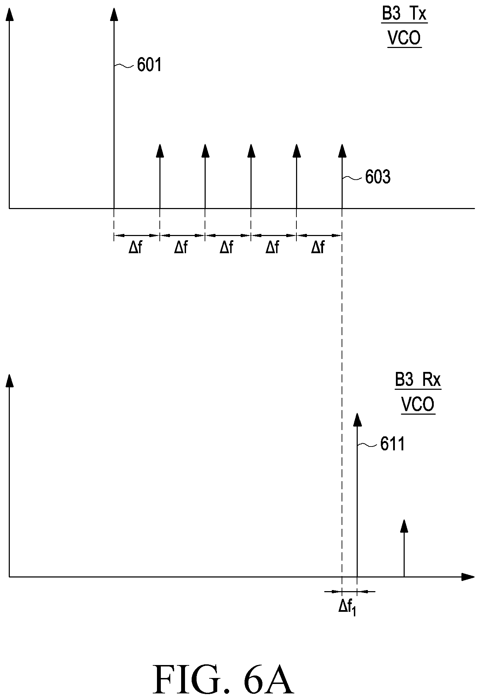

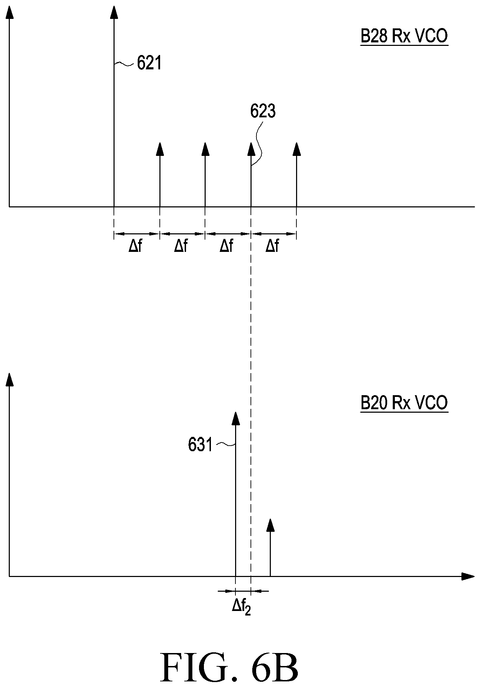

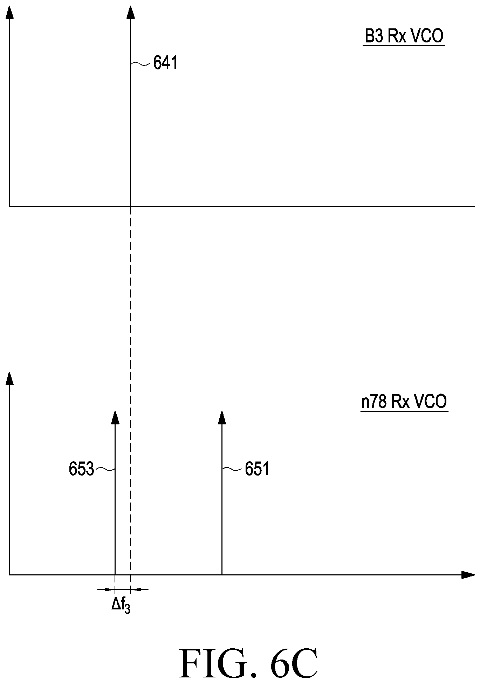

FIGS. 6A, 6B, and 6C are views illustrating an example of coupling between VCOs according to an embodiment of the disclosure.

Referring to FIG. 6A, a frequency band in which coupling between a B3 transmission VCO and a B3 reception VCO occurs is illustrated. Referring to FIG. 6A, the B3 transmission VCO may output a signal 601 of 3484 MHz for a target frequency of 1742 MHz. In an embodiment, the reference clock of the B3 transmission VCO may have 36 MHz (Δf). In an embodiment, due to the operation of the 1/N frequency divider inside the PLL, a spurious (spur) signal, which is a signal of an unintended frequency band, may be generated in the VCO output. The spur signal may mean an unwanted signal generated in a frequency band other than the frequency to be output. For example, the five-fold frequency of the reference clock and the operating frequency of the B3 transmission VCO may form a spur signal 603 of 3664 MHz. In an embodiment, the B3 reception VCO may output a signal 611 of 3674 MHz for a target frequency of 1837 MHz. Since the output signal of the B3 reception VCO and the spur signal of the B3 transmission VCO have a frequency difference (Δf1) of about 20 MHz or less of bandwidth, coupling between the B3 transmission VCO and the B3 reception VCO may occur.

Referring to FIG. 6B, a frequency band in which coupling between a B28 reception VCO and a B20 reception VCO occurs is illustrated. Referring to FIG. 6B, the B28 reception VCO may output a signal 621 of 3100 MHz for a target frequency of 775 MHz. In an embodiment, the reference clock of the B28 reception VCO may have 36 MHz (Δf). The three-fold frequency of the reference clock and the operating frequency of the B20 reception VCO may form a spur signal 623 of 3208 MHz. In an embodiment, the B20 reception VCO may output a signal 631 of 3204 MHz, which is four times the target frequency, for a target frequency of 801 MHz. Since the output signal of the B20 reception VCO and the spur signal of the B28 reception VCO have a frequency difference (Af2) of about 20 MHz or less of bandwidth, coupling between the B28 reception VCO and the B20 reception VCO may occur.

Referring to FIG. 6C, a frequency band in which coupling between a B3 reception VCO and an N78 reception VCO occurs in an EN-DC combination due to LO leakage is illustrated. Referring to FIG. 6C, the B3 reception VCO may output a signal 641 of 3674 MHz for a target frequency of 1837 MHz. In an embodiment, the N78 reception VCO may output a signal 651 of 7260 MHz, which is twice the target frequency, for a signal 653 of a target frequency of 3630 MHz. Since the frequency of the output signal of the B3 reception VCO and the target frequency of the N78 reception VCO have a frequency difference (Δf3) of about 100 MHz or less of bandwidth, coupling between the B3 reception VCO and the N78 reception VCO may occur.

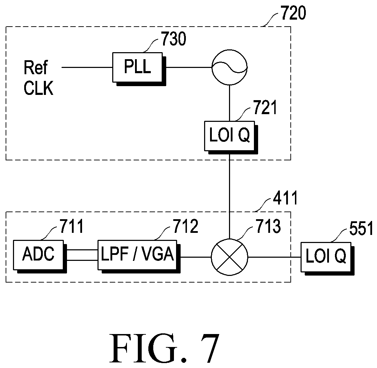

FIG. 7 is a block diagram illustrating a signal detection block according to an embodiment of the disclosure.

In an embodiment, the signal detection block 411 may be configured to include a mixer 713, an LPF 712, or an ADC 711. When the signal detection block 411 is configured to include a mixer 713 rather than the 1/N frequency divider (e.g., the frequency divider 573 of FIG. 5) of the signal detection block 411 of FIG. 5, the RFIC (e.g., the RFIC 320 of FIG. 3) may be configured to further include an additional VCO 720 electrically connected to the mixer 713. The additional VCO 720 may be configured to include an LOIQ 721 and a PLL 730. The signal detection block 411 including the mixer 713 may more accurately detect an abnormal signal as the band of the LPF 712 becomes substantially the same as the band of the reception circuit (e.g., the reception circuit 323 of FIG. 3) based on converting the reception RF signal with respect to 0 Hz.

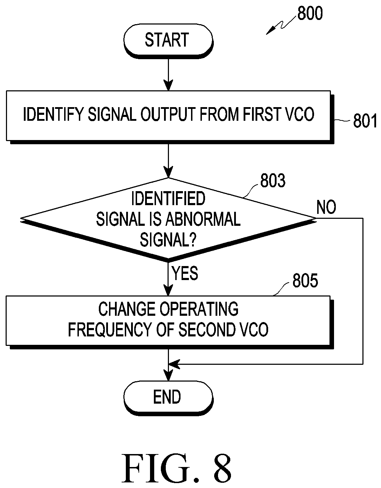

FIG. 8 is a flowchart 800 illustrating an operation of changing an operating frequency of a VCO of an electronic device according to an embodiment of the disclosure.

Referring to FIG. 8, in operation 801, in an embodiment, the electronic device (the electronic device 101 of FIG. 1) (e.g., at least one of the processor 120 of FIG. 1, the first communication processor 212 of FIG. 2A, the second communication processor 214, the integrated communication processor 260 of FIG. 2B, or the communication processor 310 of FIG. 3) may identify a signal output from the first VCO. For example, The electronic device 101 may identify a signal output from the LOIQ (e.g., the LOIQ 551 of FIG. 5) of the reception VCO (e.g., the reception VCO 403 of FIG. 4) based on the signal detection block (e.g., the signal detection block 411 of FIG. 4).

In operation 803, in an embodiment, the electronic device 101 may identify whether the identified signal is an abnormal signal. In an embodiment, the electronic device 101 may identify the strength of the identified signal based on identifying the signal-to-interference plus-noise ratio (SINR) output from the LOIQ 551. When the SINR is smaller than a reference value, the electronic device 101 may identify that it is an abnormal signal. The reference value for identifying that it is an abnormal signal may be changed according to an embodiment, and is not limited to a specific value.

In operation 805, in an embodiment, the electronic device 101 may change the operating frequency of the second VCO. For example, the electronic device 101 may control to change the operating frequency of the transmission VCO (e.g., the transmission VCO 401 of FIG. 4) based on identifying that the signal output from the LOIQ 551 is an abnormal signal. The electronic device 101 may control to change the operating frequency of the transmission VCO 401 based on selecting an operating frequency different from the frequency band in which the coupling occurs.

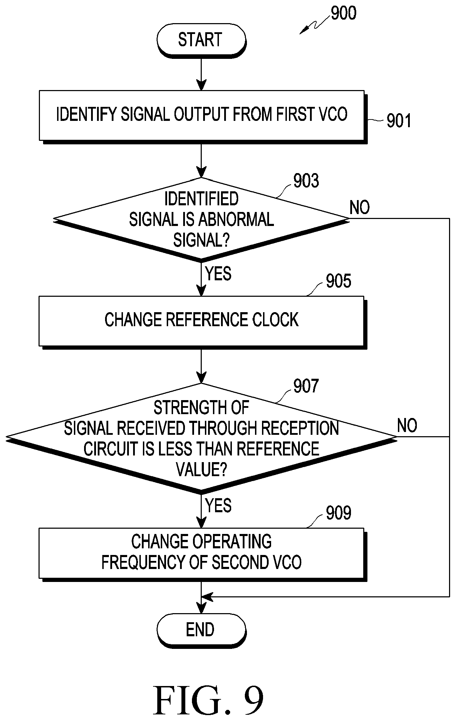

FIG. 9 is a flowchart 900 illustrating an operation of changing an operating frequency of a VCO based on a strength of a signal received through a reception circuit by an electronic device according to an embodiment of the disclosure.

Referring to FIG. 9, in operation 901, in an embodiment, the electronic device (the electronic device 101 of FIG. 1) (e.g., at least one of the processor 120 of FIG. 1, the first communication processor 212 of FIG. 2A, the second communication processor 214, the integrated communication processor 260 of FIG. 2B, or the communication processor 310 of FIG. 3) may identify a signal output from the first VCO. For example, the electronic device 101 may identify a signal output from the LOIQ (e.g., the LOIQ 551 of FIG. 5) of the reception VCO (e.g., the reception VCO 403 of FIG. 4) based on the signal detection block (e.g., the signal detection block 411 of FIG. 4). Since operation 901 is at least partially the same as or similar to operation 801, the same description as that of FIG. 8 may not be repeated.

In operation 903, in an embodiment, the electronic device 101 may identify whether the identified signal is an abnormal signal. Since operation 903 is at least partially the same as or similar to operation 803, the same description as that of FIG. 8 may not be repeated.

In operation 905, in an embodiment, the electronic device 101 may change the reference clock. In an embodiment, the electronic device 101 may change the reference clock based on the frequency divider (e.g., 1/2 frequency divider 544a and/or 2/3 frequency divider 544b of FIG. 5) so that the operating frequency of the transmission VCO (e.g., the transmission VCO 401 of FIG. 4) is adjacent to an even number-fold frequency of the operating frequency of the reception VCO 403.

In operation 907, in an embodiment, the electronic device 101 may identify whether the strength of the signal received through the reception circuit (e.g., the reception circuit 323 of FIG. 4) is less than the reference value. For example, the electronic device 101 may identify whether the SINR of the signal received through the reception circuit 323 is less than the reference value.

In an embodiment, the electronic device 101 may identify the signal-to-interference plus-noise ratio (SINR) and the reference signal received power (RSRP) of the signal received through the reception circuit 323. The electronic device 101 may identify whether the RSRP of the signal is greater than or equal to a reference value, and whether the SINR of the signal is less than a reference value. The electronic device 101 may identify whether the transmission channel and/or the reception channel of the RF signal are good based on identifying the RSRP value. For example, the electronic device 101 may identify that the transmission channel and/or the reception channel of the RF signal are good based on identifying that the RSRP value is equal to or greater than the reference value. The electronic device 101 may identify that VCO coupling occurs based on identifying that the RSRP of the signal received through the reception circuit 323 is equal to or greater than the reference value and the SINR of the reception signal is less than the reference value.

In operation 909, in an embodiment, the electronic device 101 may change the operating frequency of the second VCO. For example, the electronic device 101 may change the operating frequency of the transmission VCO 401 based on the condition of operation 907 being met. Since operation 909 is at least partially the same as or similar to operation 805, the same description as that of FIG. 8 may not be repeated.

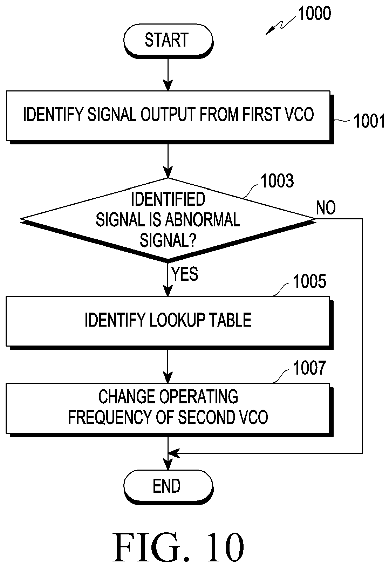

FIG. 10 is a flowchart 1000 illustrating an operation of changing an operating frequency of a VCO based on identifying a lookup table by an electronic device according to an embodiment of the disclosure.

Referring to FIG. 10, in operation 1001, in an embodiment, the electronic device (101 of FIG. 1) (e.g., at least one of the processor 120 of FIG. 1, the first communication processor 212 of FIG. 2A, the second communication processor 214, the integrated communication processor 260 of FIG. 2B, or the communication processor 310 of FIG. 3) may identify a signal output from the first VCO. Since operation 1001 is at least partially the same as or similar to operation 801, the same description as that of FIG. 8 may not be repeated.

In operation 1003, in an embodiment, the electronic device 101 may identify whether the identified signal is an abnormal signal. Since operation 1003 is at least partially the same as or similar to operation 803, the same description as that of FIG. 8 may not be repeated.

In operation 1005, in an embodiment, the electronic device 101 may identify the lookup table. In an embodiment, the electronic device 101 may identify a lookup table (LUT) associated with an operating frequency combination of the electronic device based on identifying that the identified signal is an abnormal signal. For example, the lookup table may be stored in the electronic device 101.

In operation 1007, in an embodiment, the electronic device 101 may change the operating frequency of the second VCO. The electronic device 101 may control at least one RFIC (e.g., at least one of the first RFIC 222, the second RFIC 224, the third RFIC 226, the fourth RFIC 228 of FIG. 2A, or the RFIC 320 of FIG. 3) to change the operating frequency of the transmission VCO (e.g., the transmission VCO 401 of FIG. 4) based on identifying that the operating frequency combination is a first frequency combination stored in the lookup table.

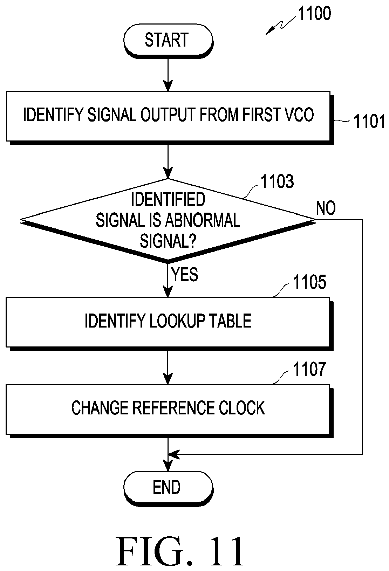

FIG. 11 is a flowchart 1100 illustrating an operation of changing a reference clock based on identifying a lookup table by an electronic device according to an embodiment of the disclosure.

Referring to FIG. 11, in operation 1101, in an embodiment, the electronic device (101 of FIG. 1) (e.g., at least one of the processor 120 of FIG. 1, the first communication processor 212 of FIG. 2A, the second communication processor 214, the integrated communication processor 260 of FIG. 2B, or the communication processor 310 of FIG. 3) may identify a signal output from the first VCO. Since operation 1101 is at least partially the same as or similar to operation 801, the same description as that of FIG. 8 may not be repeated.

In operation 1103, in an embodiment, the electronic device 101 may identify whether the identified signal is an abnormal signal. Since operation 1103 is at least partially the same as or similar to operation 803, the same description as that of FIG. 8 may not be repeated.

In operation 1105, in an embodiment, the electronic device 101 may identify the lookup table. Since operation 1105 is at least partially the same as or similar to operation 1005, the same description as that of FIG. 10 may not be repeated.

In operation 1107, in an embodiment, the electronic device 101 may change the reference clock. The electronic device 101 may control at least one frequency divider (e.g., the 1/2 frequency divider 544a and/or 2/3 frequency divider 544b of FIG. 5) of the PLL (e.g., the PLL 540 of FIG. 5) to change the reference clock of the transmission VCO (e.g., the transmission VCO 401 of FIG. 4) based on identifying that the operating frequency combination is a second frequency combination.

The electronic device 101 may control at least one frequency divider 544a and 544b of the PLL 540 to change the reference clock of the transmission VCO 401 for the remaining combinations, based on identifying that the operation frequency combination is not the first frequency combination.

According to a further aspect of the disclosure, a method for operating an electronic device is presented, the method may comprise operations of detecting (or identifying) a signal output from a first VCO included in an RF circuit of the electronic device through a signal detection block included in the RF circuit, identifying whether the detected signal is an abnormal signal based on identifying a strength of the detected signal, and controlling the RF circuit to change an operating frequency of a second VCO included in the RF circuit based on identifying that the identified signal is abnormal when the strength of the detected signal is less than a reference value.

Preferably, the method may further comprise controlling at least one frequency divider included in a PLL of the second VCO to change a reference clock of the second VCO based on identifying that the identified signal is abnormal, and controlling the RF circuit to change an operating frequency of the second VCO based on identifying that a strength of a signal received through a reception circuit included in the RF circuit is less than a reference value.

Preferably, the method may further comprise identifying a lookup table associated with an operating frequency combination of the electronic device based on identifying that the identified signal is abnormal, controlling the RF circuit to change the operating frequency of the second VCO based on identifying that the operating frequency combination is a first frequency combination, and controlling at least one frequency divider included in a PLL of the second VCO to change a reference clock of the second VCO based on identifying that the operating frequency combination is a second frequency combination and/or identifying that the operating frequency combination is not the first frequency combination.

Preferably, the method may further comprise controlling the RF circuit to turn on the signal detection block based on identifying that a transmission circuit included in the RF circuit operates and/or controlling the RF circuit to turn off the signal detection block based on identifying that a frequency of a transmission circuit included in the RF circuit is locked. In this way, the signal detection block or LO signal quality detection block can be activated and/or deactivated during certain protocol scenarios such as a locking operation to minimize current.

The electronic device as disclosed herein can be configured to perform any of the operations of the method according to the present disclosure. Likewise, the method may involve any of the functions disclosed for (components of) the electronic device. Further, operations and/or functions described in relation to the method or electronic device can equally apply for the instructions stored by the non-transitory storage medium.

The electronic device and method serve to reduce VCO coupling effects and can in particular prevent spur and/or LO leakage from crossing to a reception circuit or Rx chain coupled or couplable to the first VCO. Sensitivity degradation and throughput reduction can be prevented. When VCO coupling effects are reduced, VCOs can be positioned closer together, thus enabling more efficient use of space in an electronic device and enable further miniaturization.

According to an embodiment of the disclosure, an electronic device (e.g., the electronic device 101 of FIG. 1) may be configured to include at least one RFFE (e.g., the first RFFE 232, the second RFFE 234, the third RFFE 236, and the RFFE 330 of FIG. 2A and FIG. 2B), an RF circuit electrically connected to the at least one RFFE 232, 234, 236, and 330, and a communication processor (e.g., the processor 120 of FIG. 1, the first communication processor 212 or the second communication processor 214 of FIG. 2A, the integrated communication processor 260 of FIG. 2B, or the communication processor 310 of FIG. 3) operatively connected to the at least one RFFE 232, 234, 236, and 330 and the RF circuit. The RF circuit of the electronic device 101 may be configured to include at least one reception circuit (e.g., the reception circuit 323 of FIG. 4), at least one transmission circuit (e.g., the transmission circuit 321 of FIG. 4), a first VCO, a second VCO, and a signal detection block (e.g., the signal detection block 411 of FIG. 4) electrically connected to the first VCO. The communication processor 120, 212, 214, 260, or 310 of the electronic device 101 may be configured to control the RF circuit to change an operating frequency of the second VCO based on identifying whether a signal output from the first VCO is an abnormal signal.

In an embodiment, the signal detection block 411 of the electronic device 101 may be configured to include a frequency divider (e.g., the 1/N frequency divider 573 of FIG. 5) electrically connected to an LOIQ (e.g., the LOIQ 551 of FIG. 5) of the first VCO, a low pass filter electrically connected to the frequency divider 573, a variable gain amplifier electrically connected to the low pass filter, and an analog-to-digital (ADC) converter (e.g., the ADC 571 of FIG. 5) electrically connected to the variable gain amplifier.

In an embodiment, the electronic device 101 may be configured to further include a third VCO (e.g., the additional VCO 720 of FIG. 7). The signal detection block 411 of the electronic device 101 may be configured to include a mixer (e.g., the mixer 713 of FIG. 7) electrically connected to the LOIQ 551 of the first VCO and an LOIQ (e.g., the LOIQ 721 of FIG. 7) of the third VCO 720, a low pass filter electrically connected to the mixer 713, a variable gain amplifier electrically connected to the low pass filter, and an ADC (e.g., the ADC 711 of FIG. 7) electrically connected to the variable gain amplifier.

In an embodiment, the communication processor 120, 212, 214, 260, or 310 of the electronic device 101 may be configured to identify a signal output from an LOIQ of the first VCO. In an embodiment, the communication processor 120, 212, 214, 260, or 310 of the electronic device 101 may be configured to identify whether the identified signal is an abnormal signal based on identifying a strength of the identified signal. In an embodiment, the communication processor 120, 212, 214, 260, or 310 of the electronic device 101 may be configured to control the RF circuit to change an operating frequency of the second VCO based on identifying that the identified signal is the abnormal signal.

In an embodiment, the communication processor 120, 212, 214, 260, or 310 of the electronic device 101 may be configured to identify the strength of the identified signal based on identifying an SINR of the identified signal.

In an embodiment, the second VCO of the electronic device 101 may be configured to include a phase-locked loop (PLL) (e.g., the PLL 540 of FIG. 5). The PLL 540 may be configured to include a buffer (e.g., the buffer 525 of FIG. 5) receiving a reference clock, at least one frequency divider (e.g., the 1/2 frequency divider 544a or the 2/3 frequency divider 544b of FIG. 5) electrically connected to the buffer 525, a phase comparator (e.g., the phase comparator 542 of FIG. 5) electrically connected to the at least one frequency divider 544a and 544b, and a low pass filter (e.g., the low pass filter 541 of FIG. 5) electrically connected to the phase comparator 542.

In an embodiment, the at least one frequency divider 544a and 544b of the PLL 540 of the electronic device 101 may be one or more frequency dividers 544a and 544b connected in parallel between the buffer 525 and the phase comparator 542.

In an embodiment, the communication processor 120, 212, 214, 260, or 310 of the electronic device 101 may be further configured to identify a signal output from an LOIQ of the first VCO. In an embodiment, the communication processor 120, 212, 214, 260, or 310 of the electronic device 101 may be further configured to identify whether the identified signal is an abnormal signal based on identifying a strength of the identified signal. In an embodiment, the communication processor 120, 212, 214, 260, or 310 of the electronic device 101 may be further configured to control at least one frequency divider 544a and 544b of the PLL 540 to change a reference clock of the second VCO based on identifying that the identified signal is an abnormal signal. In an embodiment, the communication processor 120, 212, 214, 260, or 310 of the electronic device 101 may be further configured to control the RF circuit to change an operating frequency of the second VCO based on identifying that the strength of the signal received through the reception circuit 403 is less than a reference value.

In an embodiment, the communication processor 120, 212, 214, 260, or 310 of the electronic device 101 may be further configured to control the RF circuit to change an operating frequency of the second VCO based on identifying that an SINR of the signal received through the reception circuit 403 is less than a reference value.

In an embodiment, the communication processor 120, 212, 214, 260, or 310 of the electronic device 101 may be configured to identify the SINR and RSRP of the signal received through the reception circuit 403. In an embodiment, the communication processor 120, 212, 214, 260, or 310 of the electronic device 101 may be further configured to control the RF circuit to change an operating frequency of the second VCO based on identifying that the RSRP of the signal is a reference value or more and/or the SINR of the signal is less than a reference value.

In an embodiment, the communication processor 120, 212, 214, 260, or 310 of the electronic device 101 may be further configured to identify a signal output from an LOIQ of the first VCO. In an embodiment, the communication processor 120, 212, 214, 260, or 310 of the electronic device 101 may be further configured to identify whether the identified signal is an abnormal signal based on identifying a strength of the identified signal. In an embodiment, the communication processor 120, 212, 214, 260, or 310 of the electronic device 101 may be further configured to identify a lookup table associated with an operating frequency combination of the electronic device 101 based on identifying that the identified signal is the abnormal signal. In an embodiment, the communication processor 120, 212, 214, 260, or 310 of the electronic device 101 may be further configured to control the RF circuit to change an operating frequency of the second VCO based on identifying that the operating frequency combination is a first frequency combination. In an embodiment, the communication processor 120, 212, 214, 260, or 310 of the electronic device 101 may be further configured to control at least one frequency divider 544a and 544b of the PLL 540 to change a reference clock of the second VCO based on identifying that the operating frequency combination is a second frequency combination.

In an embodiment, the communication processor 120, 212, 214, 260, or 310 of the electronic device 101 may be further configured to identify a signal output from an LOIQ of the first VCO. In an embodiment, the communication processor 120, 212, 214, 260, or 310 of the electronic device 101 may be further configured to identify whether the identified signal is an abnormal signal based on identifying a strength of the identified signal. In an embodiment, the communication processor 120, 212, 214, 260, or 310 of the electronic device 101 may be further configured to identify a lookup table associated with an operating frequency combination of the electronic device based on identifying that the identified signal is the abnormal signal. In an embodiment, the communication processor 120, 212, 214, 260, or 310 of the electronic device 101 may be further configured to control the RF circuit to change an operating frequency of the second VCO based on identifying that the operating frequency combination is a first frequency combination. In an embodiment, the communication processor 120, 212, 214, 260, or 310 of the electronic device 101 may be further configured to control at least one frequency divider 544a and 544b of the PLL 540 to change a reference clock of the second VCO based on identifying that the operating frequency combination is not the first frequency combination.

In an embodiment, the communication processor 120, 212, 214, 260, or 310 of the electronic device 101 may be further configured to control the RF circuit to turn on the signal detection block 411 based on identifying that the transmission circuit 321 operates.

In an embodiment, the communication processor 120, 212, 214, 260, or 310 of the electronic device 101 may be further configured to control the RF circuit to turn off the signal detection block 411 based on identifying that the frequency of the transmission circuit 321 is locked.

According to an embodiment of the disclosure, a method for operating an electronic device 101 may include identifying a signal output from a first VCO included in an RF circuit of the electronic device 101 through a signal detection block 411 included in the RF circuit. The method for operating the electronic device 101 may include identifying whether the identified signal is an abnormal signal based on identifying a strength of the identified signal. The method for operating the electronic device 101 may include controlling the RF circuit to change an operating frequency of a second VCO included in the RF circuit based on identifying that the identified signal is an abnormal signal.

In an embodiment, the method for operating the electronic device 101 may further include controlling at least one frequency divider 544a and 544b included in a PLL 540 of the second VCO to change a reference clock of the second VCO based on identifying that the identified signal is the abnormal signal. In an embodiment, the method for operating the electronic device 101 may further include controlling the RF circuit to change an operating frequency of the second VCO based on identifying that a strength of a signal received through a reception circuit 323 included in the RF circuit is less than a reference value.

In an embodiment, the method for operating the electronic device 101 may further include identifying a lookup table associated with an operating frequency combination of the electronic device 101 based on identifying that the identified signal is the abnormal signal. In an embodiment, the operation method may further include controlling the RF circuit to change an operating frequency of the second VCO based on identifying that the operating frequency combination is a first frequency combination. The method for operating the electronic device 101 may further include controlling at least one frequency divider 544a and 544b included in a PLL 540 of the second VCO to change a reference clock of the second VCO based on identifying that the operating frequency combination is a second frequency combination.

In an embodiment, the method for operating the electronic device 101 may further include identifying a lookup table associated with an operating frequency combination of the electronic device 101 based on identifying that the identified signal is the abnormal signal. In an embodiment, the operation method may further include controlling the RF circuit to change an operating frequency of the second VCO based on identifying that the operating frequency combination is a first frequency combination. The method for operating the electronic device 101 may further include controlling at least one frequency divider 544a and 544b included in a PLL 540 of the second VCO to change a reference clock of the second VCO based on identifying that the operating frequency combination is not the first frequency combination.

In an embodiment, the method for operating the electronic device 101 may further include controlling the RF circuit to turn on the signal detection block 411 based on identifying that the transmission circuit 321 included in the RF circuit operates.

In an embodiment, the method for operating the electronic device 101 may further include controlling the RF circuit to turn off the signal detection block 411 based on identifying that the frequency of the transmission circuit 321 included in the RF circuit is locked.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Further, the structure of the data used in embodiments of the disclosure may be recorded in a computer-readable recording medium via various means. The computer-readable recording medium includes a storage medium, such as a magnetic storage medium (e.g., a ROM, a floppy disc, or a hard disc) or an optical reading medium (e.g., a CD-ROM or a DVD).

Example embodiments of the disclosure have been described above. The above-described embodiments are merely examples, and it will be appreciated by one of ordinary skill in the art various changes may be made thereto without departing from the scope of the present invention. Therefore, the disclosed embodiments should be considered from an illustrative, rather than a limiting, point of view. The scope of the invention is indicated in the claims rather than in the above-described description. All differences within the equivalent range should be construed as being included in the present invention.

## Claims

1. An electronic device (101) comprising:
memory (130) storing instructions;
a radio-frequency, RF, circuit; and
a communication processor (310) operatively connected to the memory (130) and the RF circuit,
wherein the RF circuit includes:
a first voltage-controlled oscillator, VCO, (403);
a second voltage-controlled oscillator, VCO, (401); and
a signal detection block (411) electrically connected to the first VCO (403) and configured to detect a signal output from the first VCO (403), and
wherein the instructions, when executed by the communication processor (310), cause the electronic device (101) to control the RF circuit to change an operating frequency of the second VCO (401) based on identifying that a signal output from the first VCO (403) is an abnormal signal when the strength of the signal output from the first VCO (403) as detected by the signal detection block (411) is less than a reference value.

2. The electronic device (101) of claim 1, wherein the signal detection block (411) includes:
a frequency divider (573) electrically connected to the first VCO (403), preferably an LOIQ (551) thereof;
a low pass filter (572) electrically connected to the frequency divider (573);
optionally, a variable gain amplifier electrically connected to the low pass filter (572); and
an analog-to-digital converter, ADC, (571) electrically connected to the low pass filter (572) or to the variable gain amplifier when present.

3. The electronic device (101) of claim 1 or 2, further comprising a third VCO (720),
wherein the signal detection block (411) includes:
a mixer (713) electrically connected to the first VCO (403), preferably the LOIQ (551) thereof, and the third VCO (720), preferably an LOIQ (721) thereof;
a low pass filter (712) electrically connected to the mixer (713);
optionally, a variable gain amplifier electrically connected to the low pass filter (712); and
an ADC (711) electrically connected to the low pass filter (712) or to the variable gain amplifier when present.

4. The electronic device (101) of any one of claims 1 to 3, wherein the signal detection block (411) is electrically connected to an LOIQ (551) of the first VCO (403) and the instructions, when executed by the communication processor (310), cause the electronic device (101) to:
detect a signal output from the LOIQ (551) of the first VCO (403) with the signal detection block (411);
identify whether the detected signal output from the LOIQ (551) of the first VCO (403) is an abnormal signal based on identifying a strength of the detected signal; and
control the RF circuit to change the operating frequency of the second VCO (401) when identifying that the detected signal is abnormal.

5. The electronic device (101) of any one of claims 1 to 4, wherein the instructions, when executed by the communication processor (310), cause the electronic device (101) to identify the strength of the detected signal based on identifying a signal-to-interference plus-noise ratio, SINR, of the detected signal.

6. The electronic device (101) of any one of claims 1 to 5, wherein the second VCO (401) includes a phase-locked loop, PLL, (540), and
wherein the PLL (540) includes:
a buffer (525) receiving a reference clock;
at least one frequency divider (544a, 544b) electrically connected to the buffer (525);
a phase comparator (542) electrically connected to the at least one frequency divider (544a, 544b); and
a low pass filter (541) electrically connected to the phase comparator (542),
wherein optionally the at least one frequency divider (544a, 544b) of the PLL (540) is one or more frequency dividers (544a, 544b) connected in parallel between the buffer (525) and the phase comparator (542).

7. The electronic device (101) of any one of claims 1 to 6, wherein the RF circuit further comprises a reception circuit (323) and the instructions, when executed by the communication processor (310), cause the electronic device (101) to:control at least one frequency divider (544a, 544b) of a PLL (540) of the second VCO (401) to change a reference clock of the second VCO (401) based on identifying that the detected signal is abnormal; and
control the RF circuit to change an operating frequency of the second VCO (401) when identifying that a strength of a signal received through the reception circuit (323) is less than a reference value.

8. The electronic device (101) of any one of claims 1 to 7, wherein the RF circuit further comprises a reception circuit (323) and the instructions, when executed by the communication processor (310), cause the electronic device (101) to
control the RF circuit to change the operating frequency of the second VCO (401) based on identifying that a signal-to-interference plus-noise ratio, SINR, of the signal received through the reception circuit (323) is less than a reference value.

9. The electronic device (101) of any one of claims 1 to 8, wherein the RF circuit further comprises a reception circuit (323) and the instructions, when executed by the communication processor (310), cause the electronic device (101) to control the RF circuit to change the operating frequency of the second VCO (401) based on identifying that a reference signal received power, RSRP, of the signal received through the reception circuit (323) is a reference value or more.

10. The electronic device (101) of any one of claims 1 to 9, wherein the instructions, when executed by the communication processor (310), cause the electronic device (101) to:
identify a lookup table associated with an operating frequency combination of the electronic device (101) based on identifying that the detected signal is abnormal;
control the RF circuit to change the operating frequency of the second VCO (401) based on identifying that the operating frequency combination is a first frequency combination; and
control at least one frequency divider (544a, 544b) of a PLL (540) of the second VCO (401) to change a reference clock of the second VCO (401) based on identifying that at least one of:
the operating frequency combination is a second frequency combination; or
the operating frequency combination is not the first frequency combination.

11. The electronic device (101) of any one of claims 1 to 10, further comprising at least one transmission circuit (321) and wherein the instructions, when executed by the communication processor (310), cause the electronic device (101) to control the RF circuit to at least one of:
turn on the signal detection block (411) based on identifying that the transmission circuit operates; or
turn off the signal detection block (411) based on identifying that a frequency of the transmission circuit is locked.

12. A method for operating an electronic device, the method comprising:
detecting a signal output from a first VCO included in an RF circuit of the electronic device through a signal detection block included in the RF circuit;
identifying whether the detected signal is an abnormal signal based on identifying a strength of the detected signal when the strength of the detected signal is less than a reference value; and
controlling the RF circuit to change an operating frequency of a second VCO included in the RF circuit based on identifying that the detected signal is abnormal.

13. The method of claim 12, further comprising:
controlling at least one frequency divider included in a PLL of the second VCO to change a reference clock of the second VCO based on identifying that the identified signal is abnormal; and
controlling the RF circuit to change an operating frequency of the second VCO based on identifying that a strength of a signal received through a reception circuit included in the RF circuit is less than a reference value.

14. The method of claim 12 or 13, further comprising:
identifying a lookup table associated with an operating frequency combination of the electronic device based on identifying that the identified signal is abnormal;
controlling the RF circuit to change the operating frequency of the second VCO based on identifying that the operating frequency combination is a first frequency combination; and
controlling at least one frequency divider included in a PLL of the second VCO to change a reference clock of the second VCO based on at least one of:
identifying that the operating frequency combination is a second frequency combination; or
identifying that the operating frequency combination is not the first frequency combination.

15. A computer-readable storage medium recorded with instructions, when executed by at least one processor of an electronic device, cause the electronic device to perform at least one operation comprising:
detecting a signal output from a first VCO included in an RF circuit of the electronic device through a signal detection block included in the RF circuit;
identifying whether the detected signal is an abnormal signal based on identifying a strength of the detected signal when the strength of the detected signal is less than a reference value; and
controlling the RF circuit to change an operating frequency of a second VCO included in the RF circuit based on identifying that the detected signal is abnormal.
